# EUROPEAN PATENT APPLICATION

(11) **EP 1 608 028 A1**
(43) Date of publication of application: **21.12.2005**
(21) Application number: 04722086.8
(22) Date of filing: 19.03.2004
(51) Int. Cl.: H01L 31/09, H01L 51/20

(54) **AVALANCHE MULTIPLICATION PHOTOSENSOR EMPLOYING EXTREMELY THIN MOLECULAR CRYSTAL AND PROCESS FOR FABRICATING THE SAME**

(30) Priority: 24.03.2003 JP 2003081045
(71) Applicant: Japan Science and Technology Agency, Kawaguchi-shi, Saitama 332-0012 (JP)
(72) Inventor: HIRAMOTO, Masahiro, Osaka 5691022 (JP)
(74) Representative: Schoppe, Fritz
(86) International application number: PCT/JP2004/003801
(87) International publication number: WO 2004/086518

(57) **Abstract**

A 2.5-µm-thick extremely thin single-crystal 6 of Me-PTC is sandwiched between two silver electrodes 8a and 8b. The extremely thin single-crystal 6 of Me-PTC is prepared by slicing a needle molecular crystal perpendicularly to the major axis of the crystal, wherein the stacking direction is perpendicular to a flat plane, that is, the direction combining π electron clouds is parallel to the flat plane. When the single-crystal 6 is irradiated with light under the situation where a high electric field is applied to the single-crystal 6 by using a power unit 10, photocurrent multiplied by the avalanche phenomenon flows.

## Description

### FIELD OF THE INVENTION

The invention relates to an organic opto-electronics device and a process of fabricating the device, and, particularly, to a multiplication photosensor for obtaining photo-irradiation induction current at a multiplied quantum yield by irradiating a photocurrent multiplication layer with light when voltage is applied to the photocurrent multiplication layer constituted of a photoconductive organic semiconductor.

### BACKGROUND ART

In sandwich type cells of a molecular crystal, the thickness of the molecular crystal which can be produced by crystal growth is a minimum of roughly 30 µm (micrometer). For example, it is necessary to apply a few hundred volts to obtain a field strength (10⁵ Vcm⁻¹ or more) necessary to develop a function such as electroluminescence (EL) (see W. Helfrich, W. G. Schneider, Rhys. Rev. Lett, 14, 229 (1965)). When the thickness of a molecular crystal is 30 µm, the field strength is 1.0×10⁵ Vcm⁻¹, even if a voltage of up to 300 V is applied.

The formation of a thin film using vapor deposition techniques and the like has solved the problem concerning applied voltage. For example, the required voltage to be applied to an EL device using anthracene thinned to 0.6 µm is dropped to 30 V (field strength: 5×10⁵ Vcm⁻¹) (see P.S. Vincett, et al, Thin Solid Films, 94, 171 (1982)). Also, the technologies (see C.W. Tang, S.A. VanSlyke, Appl. Phys. Lett, 51, 913 (1987)) which have become the basis of current EL devices permits the thickness of a film to be about 0.1 µm. Therefore, a field strength of 10⁶ Vcm⁻¹ can be obtained by applying a voltage of 10 V, allowing devices to be practically driven under a voltage of lower than 10 V.

However, a high price is paid for thin film formation using vapor deposition technologies and the like. Only polycrystals, not single-crystals, having many grain boundaries and amorphous thin films having random molecular arrangement can be produced as thin films.

Furthermore, thin films easily incorporate oxygen and water molecules found in the air and are also essentially inferior in purity to a single-crystal manufactured through a single-crystal precipitation process, which is very effective as a refining process.

Namely, the formation of a thin film can be attained as a result of the abandonment of characteristics such as a high carrier mobility derived from the non-grain boundary characteristics and high purity characteristics, both of which single-crystals possess. Therefore, the characteristics of organic thin film devices represented by current ELs are controlled decisively not by the essential characteristics of the organic semiconductor itself but by extemal factors, such as grain boundaries and impurities. High functions which can be expected to be exhibited by a single-crystal have not been developed so far.

No methods in which an organic single-crystal is decreased in thickness almost to that of a thin film to form a device have been proposed so far. Also, it is difficult to make organic single-crystals large enough to manufacture a device. In the case of crystals precipitated as needle-like crystals, it had been almost impossible to make these crystals into a device to evaluate their photoelectric characteristics and to utilize it as practical devices.

It is an object of the present invention to provide technologies in order to make an organic single-crystal in its original form into a film form having a film thickness (several µm) equal to that of a current vapor deposition thin film, while maintaining characteristics, such as non-grain boundary characteristics and high purity characteristics, of the organic single-crystal and to provide a sandwich cell manufactured using the thin-layered organic single-crystal.

### DISCLOSURE OF THE INVENTION

As mentioned above, the vapor deposition thin film is very thin, and a high electric field can easily be applied. However, most essential characteristics of single-crystal are lost The present invention intends to attain a novel optoelectronics device using an organic single-crystal, namely, a multiplication photosensor utilizing the avalanche phenomenon wherein the single-crystal can be made into a film having a thickness almost equal to that of a current thin film without any loss of original characteristics of a molecular single-crystal.

In other words, the multiplication photosensor of the present invention fabricates photo-irradiation induction current at a quantum yield multiplied by irradiating a photocurrent multiplication layer with light when voltage is applied to the photocurrent multiplication layer constituted of a photoconductive organic semiconductor. The photoconductive organic semiconductor of the photocurrent multiplication layer is a thin-layer single-crystal with a structure in which voltage is applied between flat surfaces of the thin layer, and the photo-irradiation induction current is multiplied by the avalanche phenomenon.

The thickness of the thin-layer single-crystal is several dozens of µm or less, preferably 10 µm or less and more preferably several µm or less. It is more advantageous that the single-crystal is thinner to apply a high electric field.

As a result, a photocurrent multiplication layer which does not lose the characteristics of the single-crystal such as a high carrier mobility derived from the non-grain boundary characteristics and high purity characteristics is made to be a thin layer whereby a sufficient electric field up to 10⁶ Vcm⁻¹ which is enough to develop functions equal to those of a vapor deposition thin film can be applied. This makes it possible to attain an organic optoelectronics device having functions which are not obtained by any one but for an organic semiconductor single-crystal, and, particularly a multiplication photosensor utilizing an avalanche effect.

Such a multiplication photosensor can be fabricated by a process involving the following steps (A) to (C).
(A) A step of embedding a photoconductive organic semiconductor single-crystal in an insulation material;
(B) A step of cutting the organic semiconductor single-crystal embedded in the insulation material, into a slice by a microtome having a specified thickness; and
(C) A step of forming an electrode layer on each flat surface of the organic semiconductor single-crystal slice obtained.

In the present invention, an organic single-crystal is embedded in an insulation material and cut by a microtome into slices having a thickness of dozens of µm, preferably 10 µm or less and more preferably several µm or less. An electrode layer is formed on each surface of the slice to make a sandwich type cell.

As explained above, the present invention provides a novel process of fabricating a sandwich type cell having the same thickness (several µm to 0.1 µm) as a vapor deposition thin film by using a molecular crystal having no grain boundary and high purity. As a result, an electric field of the order of 10⁵ Vcm⁻¹ enough to develop functions can be applied to a molecular single-crystal for the first time, which allows an organic single-crystal to develop an important phenomenon, such as the exemplified avalanche effect, which is important for the applications of multiplication photosensors.

### BRIEF DESCRIPTION OF THE DRAWINGS

Fig. 1 is a view showing the molecular structure of Me-PTC used as a material of a molecular crystal photocurrent multiplication device according to the present invention and an image of a manufactured single-crystal (in needle form).
Fig. 2 is a schematic sectional view of a furnace which is used to manufacture a single-crystal and the internal temperature of which has a gradient
Fig. 3 is formulae showing several examples of a photoconductive organic semiconductor to be used in the present invention.
Fig. 4 is a view showing a process in which a Me-PTC needle single-crystal is embedded in a resin, and the embedded single-crystal is cut into slices perpendicular to the direction of the major axis of a single-crystal.
Fig. 5 is an SEM image showing a fabricated slice of Me-PTC.
Fig. 6 is a perspective view for describing a process of setting an electrode to fabricate a sandwich type cell capable of measuring optical and electric properties.
Fig. 7 is a conceptual view showing a fabricated sandwich type cell.
Fig. 8 is a graph showing an optical response when 480 nm monochromatic light is applied under an electric field of 4×10⁵ Vcm⁻¹.
Fig. 9 is an energy diagram describing the avalanche phenomenon.
Fig. 10 is a view showing a molecular arrangement in a Me-PTC single-crystal.

### BEST MODE FOR CARRYING OUT THE INVENTION

In the present invention, the photocurrent multiplication layer is a single-crystal and both flat surfaces on which electrode layers are to be formed are not supported by a substrate and are exposed. Therefore, electrodes that apply the voltage to the photocurrent multiplication layer are not supported by any substrate and are formed directly on the flat surfaces of the photocurrent multiplication layer, and therefore, the multiplication photosensor of the present invention is a symmetric sandwich type cell.

The organic semiconductor single-crystal of the photocurrent multiplication layer is preferably stacked vertically to a flat plane.

One example of the organic semiconductor single-crystal of the photocurrent multiplication layer comprises a perylene pigment Specific examples of the semiconductor single-crystal comprising the perylene pigment include, though not limited to, a Me-PTC single-crystal and may include the following organic semiconductor single-crystals which are vapor deposition films and have a photocurrent multiplication function.

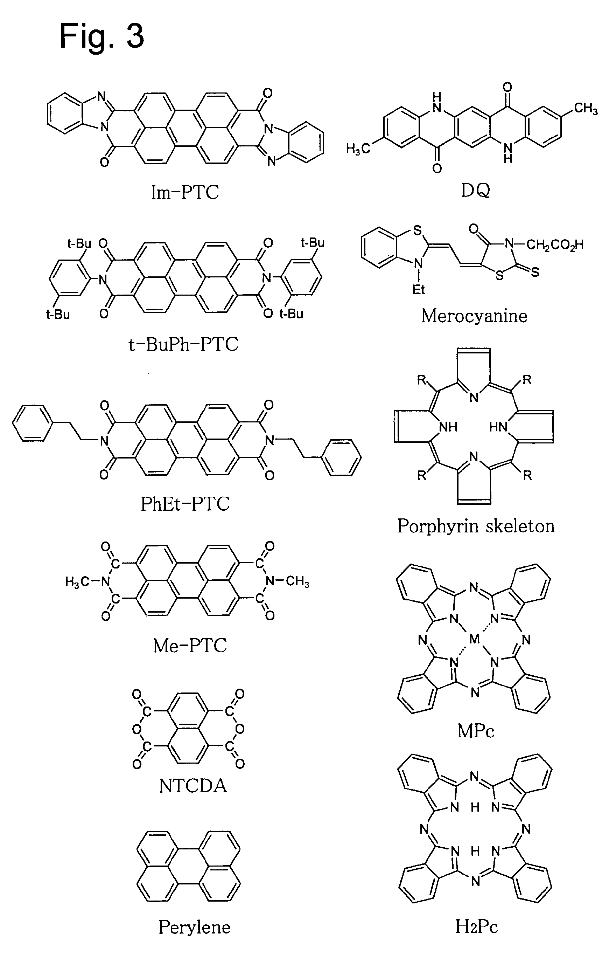

A part of these examples is illustrated in Fig. 3. They are, Namely, phthalocyanine pigments (phthalocyanine and its derivatives (MPcs respectively having various metals in its center, H₂Pc having no metal and those substituted with various groups)), quinacridone pigments (quinacridone (DQ) and its derivatives), perylene pigments (perylene and its derivatives (many derivatives differing in the type of substituent bonded to a nitrogen atom are known and examples of these derivatives include t-BuPh-PTC and PhEt-PTC, and also include Im-PTC having high photoelectric conversion ability) and naphthalene derivatives (perylene pigments with a perylene skeleton comprising naphthalene, for example, NTCDA). However, the organic semiconductor single-crystal which can be utilized in the present invention is not limited to these compounds, and single-crystals of pentacene and its derivatives, porphyrin and its derivatives, merocyanine and its derivatives and C60 (Fullerene) may also be used.

One example of the organic semiconductor single-crystal to be used in the process of the present invention is a needle crystal. In the cutting step of step (B), the crystal is cut in a direction perpendicular to the major axis of the crystal.

An example of the insulation material embedding the organic semiconductor single-crystal to be cut is a resin. Curable resins such as epoxy resin or phenol resin are preferred.

Next, the present invention will be explained in detail with reference to drawings.

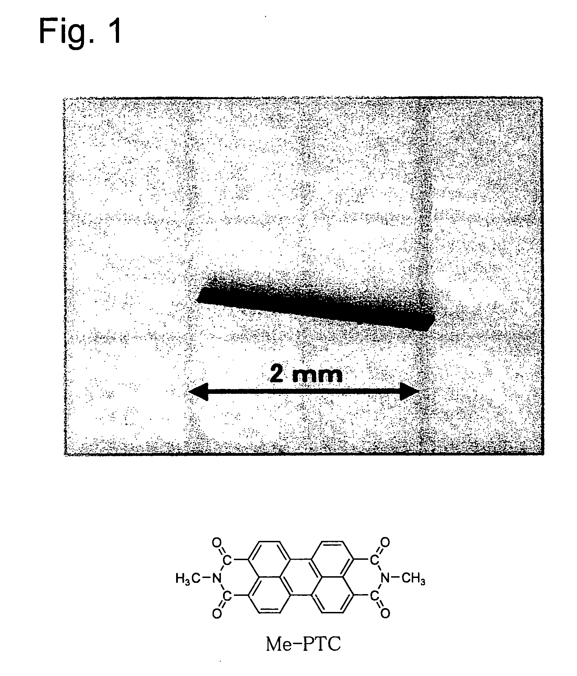

Fig. 1 is a view showing the molecular structure of Me-PTC used as a material of a molecular crystal photocurrent multiplication device according to the present invention and a photograph of a manufactured single-crystal. The size of each square on the background of Fig. 1 is 1 mm×1 mm.

A Me-PTC single-crystal is in a long thin needle form and a sandwich type cell using such a fine and small single-crystal has not been fabricated.

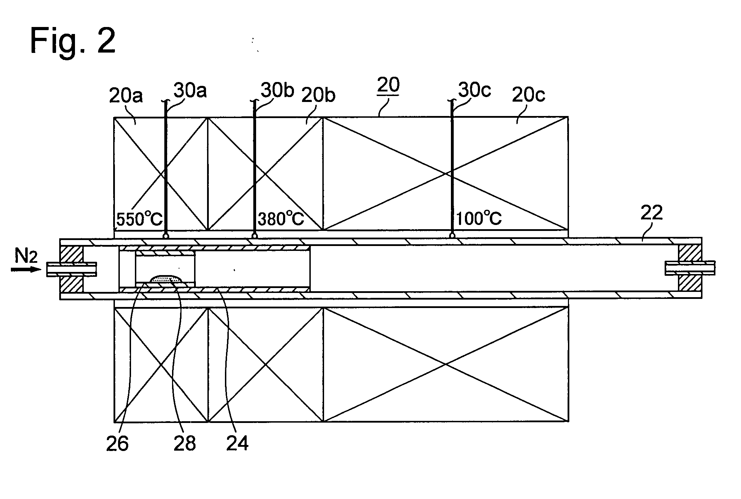

The organic semiconductor single-crystal was fabricated using the crystal growth apparatus shown in Fig. 2. This crystal growth apparatus has a structure in which a crystal growth tube 24 is arranged inside a reaction tube 22 of an electric furnace 20, and a raw material tube 26 is arranged upstream (on the left of the Figure) inside of the tube 24. An organic semiconductor powder 28 is arranged as a raw material inside of the raw material tube 26. The reaction tube 22, the crystal growth tube 24 and the raw material tube 26 are all made of quartz glass.

The apparatus is so designed as to let carrier gas flow from the upstream side of the reaction tube 20. Besides inert gas such as nitrogen, argon or helium, any gas which does not react with organic semiconductor components to be grown may be used as the carrier gas.

The electric furnace 20 arranged outside of the reaction tube 20 is constituted of three electric furnaces connected in such a manner that it can be divided into three zones; 20a to 20c, along with the direction of the length of the reaction tube 22. The zone 20a is a zone that heats the raw material 28, the zone 20b is a crystal growth zone arranged downstream from the zone 20a, and the zone 20c corresponds to the downstream area of the zone 20b. Thermocouples 30a to 30c are arranged in the furnaces corresponding to the zones 20a to 20c respectively so that each temperature of the zones 20a to 20c can be controlled independently. The temperature in the electric furnace 20 is designed so as to have a gradient descending from the upstream side (on the left in the figure) to the downstream side (on the right in the figure).

This single-crystal was fabricated using the furnace in which the inside temperature had a gradient as shown in Fig. 2 with flowing nitrogen under 1 atm in the condition that a Me-PTC powder was set to the part of the zone 20a. The temperature in the electric furnace 20 was set to 550°C at the position of the thermocouple 30a, to 380°C at the position of the thermocouple 30b, and to 100°C at the position of the thermocouple 30c. A single-crystal was grown in the zone 20b.

The condition of the production of the crystal was determined by reference to a previously reported thesis relating to the production of an organic single-crystal (see R.A. Laudise, Ch. Kloc, P.G. Simpkins, T. Siegrist, J. Crystal Growth, 187, 449-454 (1998)).

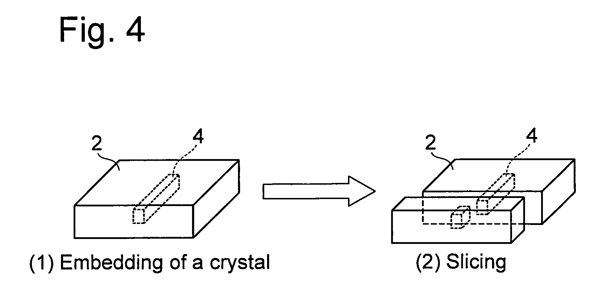

Fig. 4 shows a process of decreasing the thickness of a single-crystal to several µm.

In the production process, first the Me-PTC needle single-crystal 4 is embedded in an epoxy resin 2 which is not perfectly solidified during the course of solidification several minutes after a main agent is mixed with a hardener. Then, after the resin is perfectly solidified, it is cut into slices perpendicular to the direction of the major axis of the single-crystal by an ultra-microtome whose position can be controlled with a precision of the order of nm (nano-meter), to obtain slices. This process has succeeded in obtaining a slice having a thickness up to 2 µm so far. It is necessary to use a diamond knife to obtain a fine section. In the case of a glass knife, the section of the crystal cannot be well-cut into slices, causing the crystal to fall off from the resin and/or the section to be broken. With technology improvement and material selection, it is considered possible to cut the crystal ultimately into slices as thin as about 0.1 µm which is the thickness of a vapor deposition film.

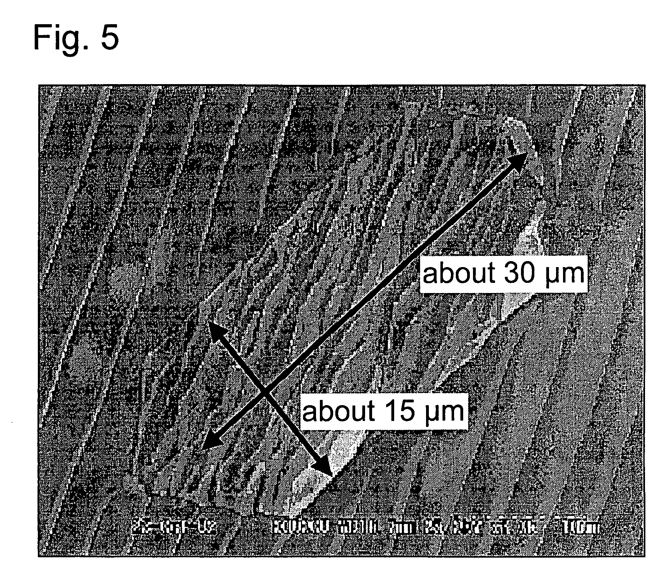

Fig. 5 shows an SEM (scanning type electron microscope) image of a section of the cut surface of the fabricated slice (thickness: 2.5 µm). A single-crystal (size: about 30 µm×15 µm) can be found embedded in an epoxy film. The observation of the section of this single-crystal is equal to the observation of a section obtained when the needle crystal (Fig. 1) is cut into slices perpendicular to the major axis of the crystal.

As mentioned above, the organic single-crystal can be cut into slices having a thickness as low as to 2.5 µm. In other words, technology for manufacturing an organic single-crystal having a thickness equal to the film thickness of a vapor deposition thin film has been established.

As the single-crystal, Me-PTC is used here. However, any type of material may be used insofar as it is an organic semiconductor and enables a single-crystal to be formed. Needle or smaller crystals are cut into slices more easily and are therefore more suitable to the process of the present invention than larger single-crystals. It is very significant that a method of measuring the electric properties of a needle single-crystal which cannot have been measured at all can be provided, taking it into account that phthalocyanine which is a typical organic semiconductor only forms a needle crystal.

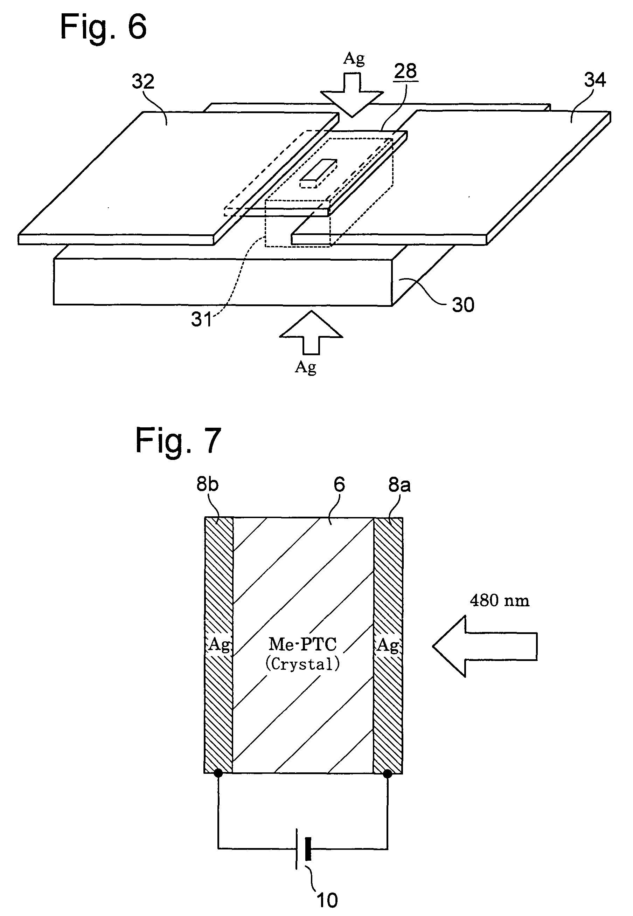

Next, a method of fitting an electrode will be explained with reference to Fig. 6 to manufacture a sandwich type cell which can measure the optical and electric properties.

First, the slice 28 in which an extremely thin single-crystal is embedded is secured to the surface of a stage 30 with a hole 31 in it by using conductive tapes 32 and 34. At this time, among these tapes, the conductive tape 32 is applied to the upper side of the slice and the conductive tape 34 is applied to the underside of the slice.

Next, a metal (silver was used in this case) used as the electrode is deposited on the slice from above and below in a thickness of, for example, 20 nm. It is to be noted that any metal may be used as the electrode if it can be deposited without breaking the thin epoxy resin slice. At this time, with the usage of a mask, the vapor deposition is carried out so that Ag deposited from above is electrically brought into contact only with the left conductive tape 32, and Ag deposited from below is electrically brought into contact only with the right conductive tape 34.

Fig. 7 shows a conceptual view of the cell thus fabricated. The cell has a structure in which the 2.5-µm-thick extremely thin single-crystal 6 is sandwiched between two silver electrodes 8a and 8b.

Thus, an extremely thin single-crystal sandwich type cell as mentioned above could be manufactured using a relatively simple method for the first time. When its cell is used to receive light when a prescribed voltage is applied to the single-crystal 6 by a power unit 10 through the electrodes 8a and 8b, photo-irradiation induction current which is multiplied at a quantum yield of 1 or more can be obtained.

It is to be noted that since this cell has no substrate and the extremely thin single-crystal is embedded in an independent epoxy resin film, it has such a strong point that a perfectly symmetric cell can be manufactured. In this point, this cell is in a situation quite different from that of a vapor deposition thin film which must be formed on a substrate. In the case of manufacturing on a substrate, Ag deposited on the substrate is not the same as Ag deposited on the organic thin film on the opposite side of the substrate even if the same Ag electrodes are used, and it is therefore impossible to manufacture a symmetric cell.

Next, the characteristics of dark currents and photocurrents which flow when voltage is applied to this cell will be explained.

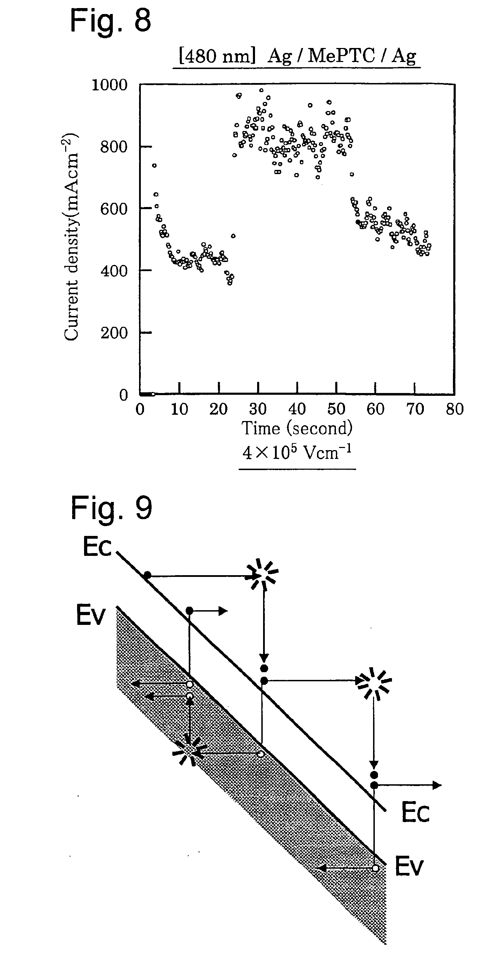

The area of the electrode is equivalent to the area of the crystal section in Fig. 7 and is 4.82×10⁻⁶ cm². 480 nm monochromatic light was applied as the light The characteristics of the cell could be evaluated in the presence of sufficient voltages applied up to 10⁶ Vcm⁻¹. The results are shown in Fig. 8. As to the photo-irradiation, light was turned on after 23 seconds and turned off after 53 seconds. As shown in Fig. 8, the dark currents reached a maximum of around 1 Acm⁻². Photo-response could be observed and the photocurrent quantum yield went up by about 5,000 times. The photocurrent quantum yield was calculated by dividing the number of carriers carried as the photocurrent by the number of photons absorbed by the organic semiconductor single-crystal. This is equivalent to one incident photon being multiplied 5000 times for detection, which shows that this cell is able to be a highly sensitive photosensor. Currents, namely both the dark current and the photocurrent, flowing when a high electric field is applied are accompanied by a random noise, and photo-responsive speed is very high both in the first transition and in the last transition. As the currents are accompanied by noises peculiar to the avalanche phenomenon, the phenomenon observed here is considered to be the avalanche phenomenon.

In an avalanche phenomenon, as shown in Fig. 9, charges injected from the electrode, or electrons (black solid circles) or holes (white solid circles) created by irradiation with light are accelerated under a high electric field and collide with the crystal lattice to create new electron-hole pairs. This process is repeated many times and, therefore, the number of carriers (current) is multiplied dramatically, which amplifies dark current in the former case and photocurrent in the latter case. In order to cause this process, carriers must be accelerated until they have energy larger than the bandgap. The kinetic energy (E) that a carrier has is represented by the following formula.
E = (1/2)mv²
- v:: Running speed of the carrier
- m:: Effective mass of the carrier
- v:: MF (F: Field strength, M: Carrier mobility)

A large mobility (M) is required to acquire high energy. Also, both holes and electrons are propagated, leading to frequent recombination of these holes and electrons, causing random current noises to be generated. Also, as travel distance (cell thickness) increases, the number of collisions with the lattice increases. Because of this, the propagation of carriers is further promoted, and larger currents are observed. These phenomena are good features showing the evidence of the avalanche phenomenon. Such a thing is not seen in other phenomenon.

At this, a cell having a thickness of 5 µm which is twice the thickness (2.5 µm) in the direction of the section was fabricated as a trial. As a result, the dark current of the 5 µm cell reached 8 Acm⁻², 500 times or more of that of the dark current of the 2.5 µm cell in the same field strength (1.6×10⁵ Vcm-1). It is known that in the avalanche phenomenon, the longer the travel distance of carriers, more ionization takes place, and the current increases. This result suggests that the dark current and photocurrent accompanied by noises which were observed this time are due to the avalanche phenomenon.

The results of this embodiment reflects high mobility which the organic single-crystal possesses and shows the presence of a phenomenon which cannot be observed in the case of a vapor deposition film which has many grain boundaries and difficulty in acceleration of carriers. High mobility in a molecular crystal (about 1 cm² V⁻¹s⁻¹ at ambient temperature and about 200 cm² V⁻¹s⁻¹ under cooling at 10 K) is reported in the case of perylene and naphthalene described in a reference (see W. Warta, R Stehle, N. Karl, Appl. Phys. A, 36, 163 (1985)).

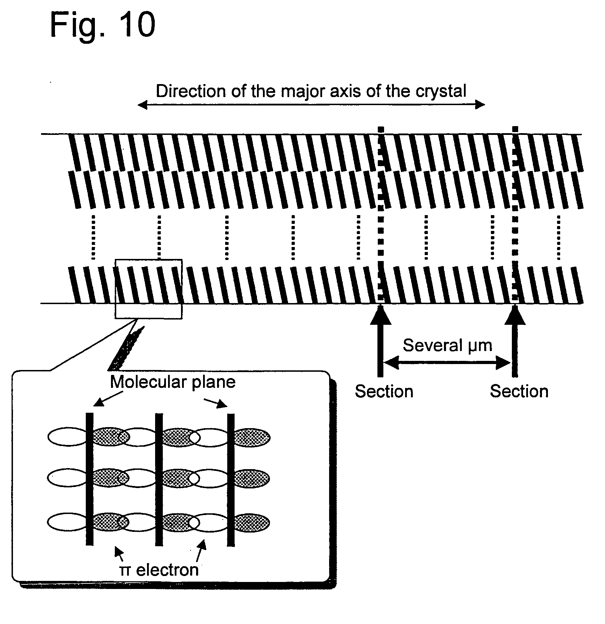

When the molecular crystal is in a needle form, as shown in Fig.10, the stacking direction is perpendicular to a flat plane, that is, the direction combining π electron clouds is parallel to the flat plane. Namely, in the single-crystal sliced perpendicular to the major axis of the crystal, π electron clouds form a line so as to constitute a path of electrons between two electrodes, and high mobility in this direction is convenient for the acceleration of electrons and is considered to be one of the reasons why the avalanche phenomenon is caused.

The avalanche phenomenon is well known in inorganic semiconductor single-crystals such as silicon and germanium. However, there is no example of an organic single-crystal in which the avalanche phenomenon is observed.

As a result of the present invention, an organic single-crystal having no grain boundary and high purity is made to be very thin allowing sufficient electric field to be applied, and it can be said that because of this, the avalanche phenomenon caused by high mobility of a single-crystal is observed for the first time. This is a new function of an organic single-crystal.

Because there are organic semiconductors having various absorption wavelengths, the present invention can provide avalanche multiplication photosensors which have sensitivity to lights having various different wavelengths ranging from the ultraviolet region to the infrared region and which is highly responsive and has a high multiplication factor.

### INDUSTRIAL APPLICABILITY

The multiplication photosensor according to the present invention may be utilized as a photo-detecting element and is particularly suitable for detecting weak light The present invention may be therefore utilized for photo sensor, optical computer, display and imaging devices such as imaging tubes used in devices, for example, CCDs and television cameras.

## Claims

1. An multiplication photosensor which fabricates photo-irradiation induction current at a quantum yield multiplied by irradiating a photocurrent multiplication layer with light when voltage is applied to the photocurrent multiplication layer constituted of a photoconductive organic semiconductor, wherein;
the photoconductive organic semiconductor of the photocurrent multiplication layer is a thin-layer single-crystal and has a structure in which the voltage is applied between flat surfaces of the thin layer; and
the photo-irradiation induction current is multiplied by the avalanche phenomenon.

2. The multiplication photosensor according to Claim 1, wherein the electrodes that apply the voltage to the photocurrent multiplication layer are not supported by any substrate but are formed directly on the flat surfaces of the photocurrent multiplication layer.

3. The multiplication photosensor according to Claim 1 or 2, wherein the single-crystal has a stacking direction perpendicular to the flat surfaces.

4. The multiplication photosensor according to any one of Claims 1 to 3, wherein the single-crystal is made of a perylene pigment

5. A process of fabricating a multiplication photosensor comprising the following steps (A) to (C):
(A) a step of embedding a photoconductive organic semiconductor single-crystal with an insulation material;
(B) a step of cutting the organic semiconductor single-crystal embedded in the insulation material into a slice by a microtome having a specified thickness; and
(C) a step of forming an electrode layer on each flat surface of the organic semiconductor single-crystal slice obtained.

6. The process according to Claim 5, wherein the organic semiconductor single-crystal is a needle crystal and the step (B) comprises cutting in a direction perpendicular to the major axis of the crystal.

7. The process according to Claim 5 or 6, wherein the insulation material is a resin.
